(19) Europäisches Patentamt

European Patent Office

Office européen des brevets

(11) **EP 0 847 138 A2**

(12) **EUROPÄISCHE PATENTANMELDUNG**

(43) Veröffentlichungstag:
10.06.1998 Patentblatt 1998/24

(51) Int. Cl.⁶: **H03H 19/00**

(21) Anmeldenummer: 97121007.5

(22) Anmeldetag: 29.11.1997

(84) Benannte Vertragsstaaten:
**AT BE CH DE DK ES FI FR GB GR IE IT LI LU MC NL PT SE**
Benannte Erstreckungsstaaten:
**AL LT LV MK RO SI**

(30) Priorität: 06.12.1996 DE 19650681

(71) Anmelder:
**Zentrum Mikroelektronik Dresden GmbH
D-01109 Dresden (DE)**

(72) Erfinder: **Krauss, Mathias, Dr.
72119 Ammerbuch (DE)**

(74) Vertreter:
**Adler, Peter, Dipl.-Ing. et al
Patentanwälte
Lippert, Stachow, Schmidt & Partner
Postfach 19 24 38
01282 Dresden (DE)**

(54) **Kapazitive Sensoranordnung**

(57)     Die Erfindung betrifft eine kapazitive Sensoranordnung mit einem Ladungsbalance-Frequenzumsetzer. Diese besteht aus einem Operationsverstärker, zwischen dessen Ausgang und dessen invertierendem Eingang ein Integrationskondensator geschaltet und dessen nichtinvertierender Eingang mit einem Bezugspotential verbunden ist. Weiterhin besteht die Anordnung aus einem ersten Kondensator, dessen eine Elektrode mit einem ersten Potential oder mit dem Bezugspotential und die andere Elektrode mit Bezugspotential oder dem invertierenden Eingang des Operationsverstärkers verbindbar ist, und einem zweiten Kondensator, dessen eine Elektrode entweder mit einem zweiten Potential oder mit dem Bezugspotential und dessen andere Elektrode mit Bezugspotential oder dem invertierenden Eingang verbunden ist. Schließlich ist an den Ausgang des Operationsverstärkers ein Komparator geschalten und die Anordnung mit einem Taktgenerator zur Steuerung der Schaltvorgänge versehen.

Der Erfindung liegt die Aufgabe zugrunde, eine Sensoranordnung nach dem Ladungsbalanceprinzip anzugeben, die unter Gewährleistung einer hohen Meßgenauigkeit einfach herstellbar und robust für verschiedene Einsatzgebiete ist.

Dies wird dadurch gelöst, daß das erste Potential gleich dem zweiten Potential ist, das ein Hilfspotential (U) darstellt, und daß der erste ($C_1$) und der zweite Kondensator ($C_2$) Teilkondensatoren eines Differentialkondensators (14) sind.

Fig. 1

**Beschreibung**

Die Erfindung betrifft eine kapazitive Sensoranordnung mit einem Ladungsbalance-Frequenzumsetzer. Diese besteht aus einem Operationsverstärker, zwischen dessen Ausgang und dessen invertierendem Eingang ein Integrationskondensator geschaltet und dessen nichtinvertierender Eingang mit einem Bezugspotential verbunden ist. Weiterhin besteht die Anordnung aus einem ersten Kondensator, dessen eine Elektrode mit einem ersten Potential oder mit dem Bezugspotential und die andere Elektrode mit Bezugspotential oder dem invertierenden Eingang des Operationsverstärkers verbindbar ist, und einem zweiten Kondensator, dessen eine Elektrode entweder mit einem zweiten Potential oder mit dem Bezugspotential und dessen andere Elektrode mit Bezugspotential oder dem invertierenden Eingang verbunden ist. Schließlich ist an den Ausgang des Operationsverstärkers ein Komparator geschaltet und die Anordnung mit einem Taktgenerator zur Steuerung der Schaltvorgänge versehen.

Aus dem deutschen Patent DD 228 132 ist ein Analog-Digitalwandler bekannt, der mittels geschalteten Kapazitäten nach dem Ladungsbalance-Prinzip arbeitet. Die diesbezügliche Schaltungsanordnung besteht aus einem Operationsverstärker zwischen dessen Ausgang und dessen invertierendem Eingang ein Integrationskondensator $C_I$ geschaltet ist. Der nichtinvertierende Eingang des Operationsverstärkers ist mit einem Bezugspotential, welches das Massepotential darstellt, verbunden.

Weiterhin ist ein Eingangskondensator $C_E$ und ein Referenzkondensator $C_R$ vorgesehen. Eine Elektrode des Eingangskondensators $C_E$ ist über einen ersten Umschalter entweder mit einem Eingangspotential $U_E$ oder mit Bezugspotential verbunden. Die andere Elektrode des Eingangskondensators ist mittels eines zweiten Umschalters zum gleichen Zeitpunkt wie der erste Umschalter mit Bezugspotential oder dem invertierenden Eingang des Operationsverstärkers verbunden.

Die eine Elektrode des Referenzkondensators $C_R$ ist über einen dritten Umschalter entweder mit einem Referenzpotential $U_R$ oder mit Bezugspotential verbunden. Die andere Elektrode des Referenzkondensators $C_R$ ist mittels eines vierten Umschalters zum gleichen Zeitpunkt wie der dritte Umschalter mit Bezugspotential oder dem invertierenden Eingang verbunden.

An dem Ausgang des Operationsverstärkers ist ein Komparator geschaltet.

Der erste und der zweite Umschalter werden synchron mit dem Taktsignal eines Taktgenerators geschalten. Der dritte und der vierte Umschalter werden synchron von dem Ausgang einer Torschaltung geschalten, wobei dann ein Schaltsignal ausgegeben wird, wenn der Komparatorausgang ein Überschreiten seiner Schwellspannung signalisiert.

In einem Takt wird nun die Ladungsmenge $U_E \cdot C_E$ an den Integrationskondensator übergeben. Dies geschieht für eine Anzahl n von Takten, während am Ausgang des Operationsverstärkers die Schwellspannung des Komparators wiederholt überschritten wird, wodurch dieser an seinem Ausgang jeweils einen anderen Schaltzustand einnimmt. Dabei wird bei Auftreten eines Taktimpulses ein Schaltimpuls für den dritten und den vierten Umschalter ausgelöst. Damit wird bei jedem Überschreiten der Schwellspannung von dem Integrationskondensator $C_I$ eine Ladungsmenge $U_R \cdot C_R$ abgezogen. Die Ausgangsspannung des Operationsverstärkers sinkt jeweils unter die Schwellspannung des Komparators, wodurch dieser wieder seinen alten Ausgangszustand einnimmt.

Nunmehr werden wieder zu jedem Takt Ladungen $U_E \cdot C_E$ an die Integrationskapazität $C_I$ gegeben, bis sich am Ausgang des Operationsverstärkers wieder eine Spannung einstellt, die über der Schwellspannung liegt. Damit wiederholt sich der Vorgang.

Die Anzahl z der Impulse am Torausgang ist im Verhältnis zur Anzahl der Taktimpulse ein Maß für das Spannungsverhältnis zwischen $U_E$ und $U_R$, da gilt

$$\frac{U_E}{U_R} = \frac{C_R}{C_E} \cdot \frac{n}{z}.$$

Mit bekannten Größen für $U_R$, $C_R$, $C_E$ und n ist somit z ein digitaler Wert für die analoge Größe $U_E$.
In einer Lösung nach der deutschen Offenlegungsschrift 41 15 534 wird dieses Ladungsbalanceverfahren zur Messung einer Kapazität verwendet. Durch die Ausführung des Eingangskondensators $C_E$ als Fotokondensator und durch eine Kenntnis der Größen von $U_E$, $U_R$, $C_R$ und n ist mit z die Größe der Kapazität von $C_E$ digital auszudrücken und damit die analoge Größe der Lichtintensität digital auszudrücken.

Eine derartige Lösung zeigt den Nachteil, daß der Referenzkondensator $C_R$ ein festes Bauelement ist, welches in der erforderlichen Genauigkeit zumindest bei einer Integration der Schaltungsanordnung schwer herstellbar ist und dessen Werte einer Drift unterliegen.

Kapazitive Sensoren, wie sie beispielsweise in der deutschen Patentschrift 41 36 995 angegeben sind, sind bei dieser bekannten Lösung nicht einsetzbar.

Der Erfindung liegt damit die Aufgabe zugrunde, eine Sensoranordnung nach dem Ladungsbalanceprinzip anzugeben, die unter Gewährleistung einer hohen Meßgenauigkeit einfach herstellbar und robust für verschiedene Einsatzgebiete ist.

Gemäß der Erfindung wird die Aufgabe dadurch gelöst, daß das erste Potential gleich dem zweiten Potential ist, welches ein Hilfspotential darstellt. Der erste und der zweite Kondensator sind dabei als Teilkondensatoren eines Differentialkondensators ausgebildet.

Unter einem Differentialkondensator soll hierbei ein solcher Kondensator verstanden werden, der aus zwei Teilkondensatoren besteht, deren Kapazitäten sich gegenläufig ändern, wobei die Gesamtkapazität konstant bleibt. Die Änderung der Teilkapazitäten wird dabei durch eine äußere Beeinflussung bewirkt.

Hierbei wird ein besonderer Referenzkondensator vermieden. Beide Teilkondensatoren unterliegen den gleichen Bedingungen, so daß sich Fehler oder Drifterscheinungen gegeneinander aufheben. Nicht zuletzt dadurch wird die Messgenauigkeit erhöht.

Durch diese Anordnung wird die Bedingung

$$\frac{U_1}{U_2} = \frac{C_2}{C_1} \cdot \frac{n}{z} \text{ mit } U_1 = U_2$$

erfüllt, d.h.

$$\frac{z}{n} = \frac{C_2}{C_1},$$

wodurch das Verhältnis aus $C_2$ und $C_1$ digital ausgedrückt werden kann.

In einer Ausgestaltung der Erfindung ist vorgesehen, daß der Ausgang des Komparators an einen Eingang eines ersten UND-Gliedes anliegt, an dessen zweitem Eingang der Ausgang des Taktgenerators anliegt. Dabei ist der Ausgang des UND-Gliedes mit einer Schalteranordnung zum Schalten der ersten und/oder zweiten Elektrode des zweiten Kondensators steuernd verbunden. Ein invertierter Ausgang des Komparators liegt an einen Eingang eines zweiten UND-Gliedes an, an dessen zweiten Eingang der Ausgang des Taktgenerators anliegt. Dabei ist der Ausgang des zweiten UND-Gliedes mit einer Schalteranordnung zum Schalten der ersten und/oder zweiten Elektrode des ersten Kondensators steuernd verbunden.

Mit dieser Ausgestaltung wird erreicht, daß die Bedingung

$$C_2 \geq C_1$$

nicht eingehalten zu werden braucht, nach der für eine Messung nur der halbe Hub eines Differentialkondensators zur Verfügung steht. Dies ergibt sich daraus, daß entweder $C_1$ oder $C_2$ an dem invertierten Eingang des Operationsverstärker anliegen. Somit gilt

$$(n - z) \cdot C_1 = z \cdot C_2$$

und damit

$$\frac{C_1}{C_1 + C_2} = \frac{z}{n}.$$

Damit kann praktisch der gesamte Hub des Differentialkondensators, z.B. eine 180°-Drehung eines Differential-Drehkondensators genutzt werden.

In einer Fortbildung der Anordnung ist ein erster Schalter zum Schalten der ersten Elektrode des ersten Kondensators und ein zweiter Schalter zum Schalten der zweiten Elektrode des ersten Kondensators vorgesehen. Dabei sind die Steuereingänge der beiden Schalter mit dem Ausgang des Taktgenerators oder des zweiten UND-Gliedes verbunden. Weiterhin ist ein dritter Schalter zum Schalten der ersten Elektrode des zweiten Kondensators und ein vierter Schalter zum Schalten der zweiten Elektrode des zweiten Kondensators vorgesehen, wobei Steuereingänge der beiden Schalter mit dem Ausgang des ersten UND-Gliedes verbunden sind. Der Differentialkondensator ist als Vierpolkondensator ausgebildet.

Eine andere Möglichkeit der Fortbildung der erfindungsgemäßen Anordnung besteht darin, daß anstelle des zweiten und des vierten Schalters ein fünfter Schalter vorgesehen ist, an dem die zweite Elektrode des ersten Kondensators und die zweite Elektrode des zweiten Kondensators gemeinsam verbunden anliegen und dessen Steuereingang mit dem Ausgang des Taktgenerators verbunden ist. Diese sind zwischen invertierendem Eingang und Bezugspotential schaltbar. Der erste Schalter ist zum Schalten der ersten Elektrode des ersten Kondensators angeordnet, dessen Steuereingang mit dem Ausgang des Taktgenerators oder des zweiten UND-Gatters verbunden ist. Der dritte Schalter ist zum Schalten der ersten Elektrode des zweiten Kondensators angeordnet, wobei dessen Steuereingang mit dem Ausgang des ersten UND-Gatters verbunden ist. Hierbei ist der Differentialkondensator als Dreipolkondensator ausgebildet.

Somit ist es möglich, dreipolige Differentialkondensatoren einzusetzen, deren Fertigungsaufwand geringer ist.

Eine weitere Ausbildung der erfindungsgemäßen Anordnung ist dadurch gekennzeichnet, daß an den Komparatorausgang ein Impulsformer angeschlossen ist, an dessen Eingang Impulse mit einem Tastverhältnis von 0,5 anlegbar sind. Die Ausgangsimpulse dieses Impulsformers weisen eine Impulsbreite auf, die näherungsweise der Taktperiode der Taktimpulsfolge entsprechen. An diesem Impulsformer ist ein Tiefpaß angeschlossen, dessen Ausgang einen analogen Ausgang darstellt, dessen Spannung $U_{out}$ im Verhältnis zur Betriebsspannung $V_{dd}$

$$\frac{U_{out}}{V_{dd}} = \frac{C_1}{C_1 + C_2}$$

geteilt ist.

Wenn der Ausgang des Komparators eine Anzahl z von Impulsen liefert, die im Verhältnis zur Anzahl n der Taktimpulse ein digitales Maß für das Verhältnis der Teilkondensatoren darstellt, so wird am Ausgang des Impulsformers nach Tiefpaßfilterung ein analoges Signal ausgegeben, das proportional zum Verhältnis der Teilkapazitäten, also beispielsweise zum Drehwinkel eine Potentiometers ist. Mit dieser Ausführungsform kann somit die gesamte Anordnung als Dreipol mit den Anschlüssen $V_{dd}$, Bezugspotential und $U_{out}$ angeschlossen werden und damit beispielsweise der Substitution von Potentiomentern dienen.

Besonders zweckmäßig ist es, daß das Bezugspotential auf Massepotential und das Hilfspotential (U) auf Betriebspannung $V_{dd}$ liegt. Damit wird die Bereitstellung zusätzlicher Potentiale vermieden.

Die Erfindung soll nunmehr anhand eines Ausführungsbeispieles näher erläutert werden. In den zugehörigen Zeichnungen zeigt

Fig. 1    die Schaltungsanordnung einer Ausführungsform gemäß Anspruch 3,

Fig. 2    die Schaltungsanordnung einer Ausführungsform gemäß Anspruch 4,

Fig. 3    eine Darstellung eines vierpoligen Drehkondensators,

Fig. 4    eine Darstellung eines vierpoligen kapazitiven Drucksensors und

Fig. 5    eine Darstellung eines dreipoligen kapazitiven Drucksensors.

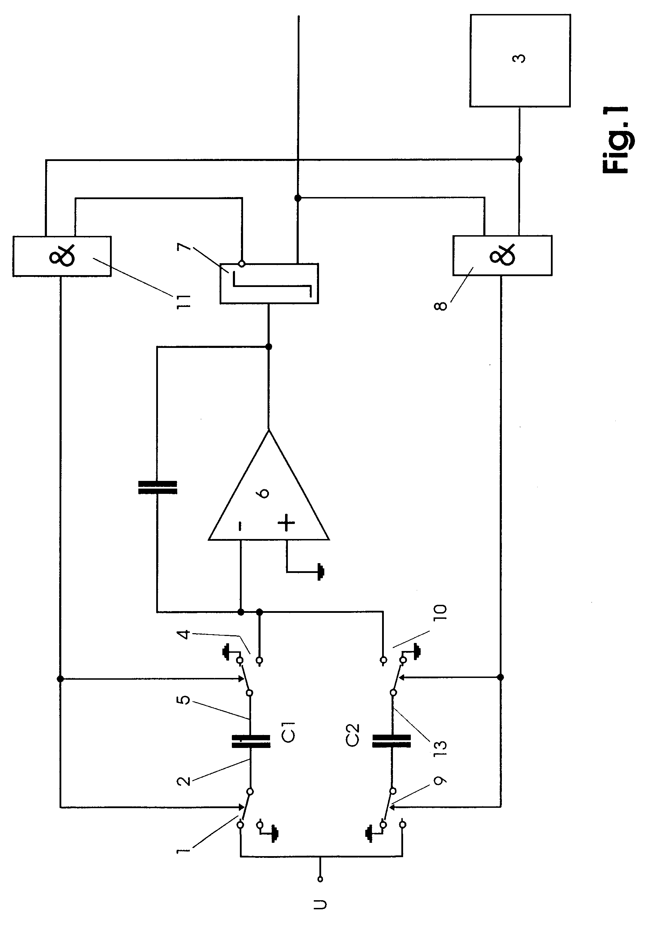

Wie in Fig. 1 dargestellt, verbindet der erste Schalter 1 die erste Elektrode 2 des ersten Kondensators $C_1$ mit dem Hilfspotential U. Beim nächsten Takt des Taktgenerators 3 schalten der erste Schalter 1 die erste Elektrode 2 des ersten Kondensators C1 an Bezugspotential, wofür das Massepotential verwendet wird, und der zweite Schalter 4 die zweite Elektrode 5 an den invertierten Eingang des Operationsverstärkers 6. Damit übernimmt der Integrationskondensator $C_I$ die Ladungsmenge aus $C_1$.

Dieser Vorgang wird für einige Takte wiederholt, bis der Ausgang des Operationsverstärkers 6 auf einen solchen Wert angestiegen ist, daß der ihm nachgeschaltete Komparator 7 seinen Ausgangswert ändert. Sodann wird über das erste UND-Glied 8 bei dem nächsten Taktimpuls ein Schaltimpuls an den dritten und den vierten Schalter 9 und 10 gegeben, so daß die Ladungsmenge, die sich zwischenzeitlich in dem zweiten Kondensator $C_2$ gesammelt hat, von dem Integrationskondensator $C_I$ abgezogen wird. Damit sinkt die Ausgangsgröße des Operationsverstärkers 6 und der Ausgang des Komparators 7 nimmt seinen ursprünglichen Wert an. Bis zu diesem Zeitpunkt ist der Takt an dem ersten und zweiten Schalter 1 und 4 über das zweite UND-Glied 11 gesperrt.

Mit Änderung des Ausganges des Komparators 7 kann der Vorgang wiederholt werden. Die Anzahl z der an dem Ausgang des Komparators 7 anliegenden Impulse stellen im Verhältnis zur Anzahl n der Taktimpulse ein digitales Maß für das Verhältnis aus $C_1$ und $C_1 + C_2$ dar.

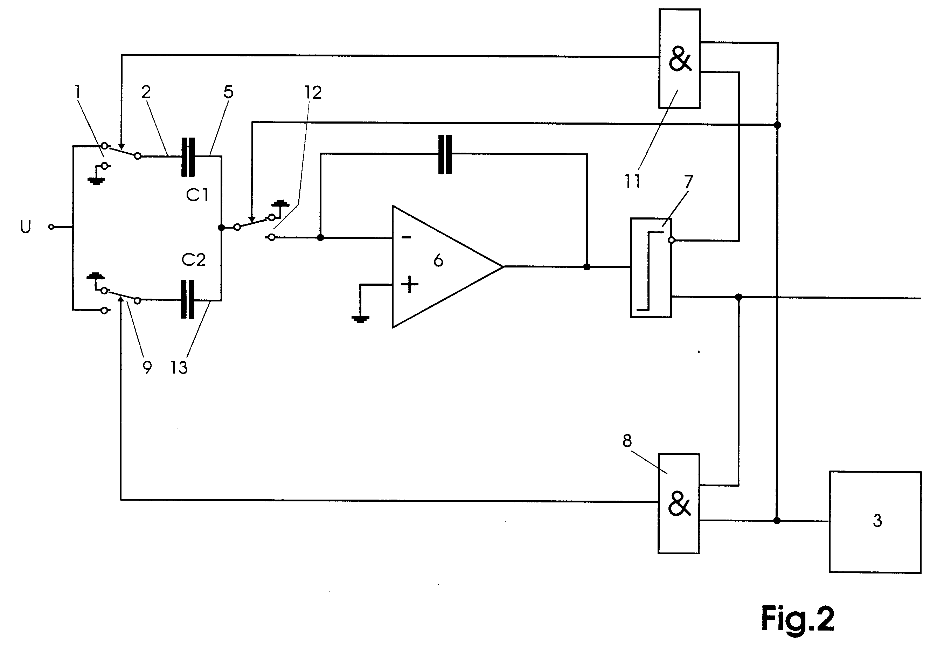

Wie in Fig. 2 dargestellt, ist anstelle des zweiten Schalters 4 und des vierten Schalters 10 gemäß Fig. 1 ein fünfter Schalter 12 vorgesehen. An diesem fünften Schalter 12 sind die zweite Elektrode 5 von $C_1$ und die zweite Elektrode 13 von $C_2$ zusammgeschaltet. Hier wird die Ladungsträgerbalance nur über den ersten Schalter 1 und den dritten Schalter 9 realisiert. Der fünfte Schalter 12 wird direkt von den Impulsen des Taktgenerators 3 geschaltet.

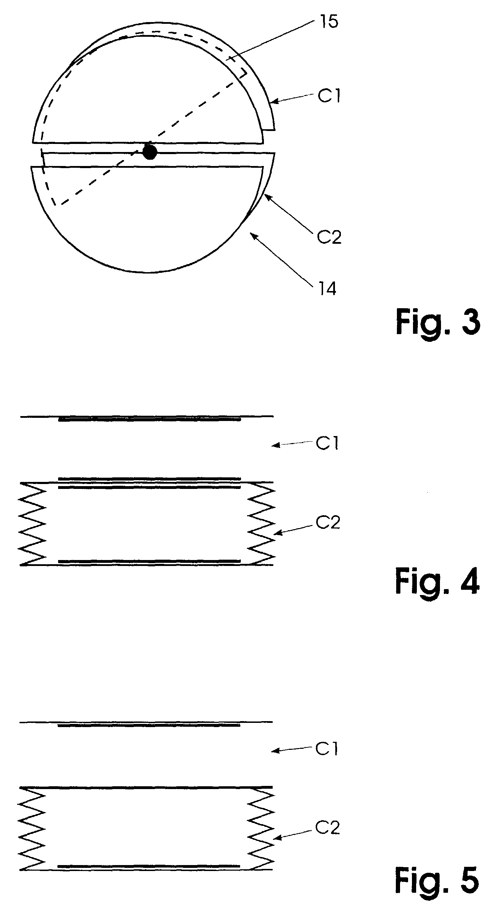

Der Vorteil der Schaltung entsprechend Fig. 2 besteht darin, daß ein dreipoliger Differentialkondensator 14, wie er in Fig. 5 dargestellt ist, eingesetzt werden kann.

Bei einer Schaltungsanordnung, wie sie in Fig. 1 dargestellt ist, ist ein vierpoliger Differentialkondensator 14 erforderlich. Dieser kann gemäß Fig. 3 dadurch realisiert werden, daß zwischen den Elektroden zweier Teilkondensatoren $C_1$ und $C_2$ ein Dielektrikum 15 drehbar ist.

## Bezugzeichenliste

| | |
|---|---|
| 1 | erster Schalter |
| 2 | erste Elektrode von $C_1$ |
| 3 | Taktgenerator |
| 4 | zweiter Schalter |
| 5 | zweite Elektrode von $C_1$ |
| 6 | Operationsverstärker |
| 7 | Komparator |
| 8 | erstes UND-Glied |
| 9 | dritter Schalter |
| 10 | vierter Schalter |
| 11 | zweites UND-Glied |
| 12 | fünfter Schalter |
| 13 | zweite Elektrode von $C_2$ |
| 14 | Differentialkondensator |
| 15 | Dielektrikum |
| $C_1$ | erster Kondensator |
| $C_2$ | zweiter Kondensator |
| U | Hilfspotential |

## Patentansprüche

1.    Kapazitive Sensoranordnung mit einem Ladungsbalance-Frequenzumsetzer, bestehend aus einem Operationsverstärker, zwischen dessen Ausgang und dessen invertierendem Eingang ein Integrationskondensator geschaltet und dessen nichtinvertierender Eingang mit einem Bezugspotential verbunden ist, mit einem ersten Kondensator, dessen erste Elektrode mit einem ersten Potential oder mit dem Bezugspotential und die zweite Elektrode mit Bezugspotential oder dem invertierenden Eingang des Operationsverstärkers verbindbar ist, und einem zweiten Kondensator, dessen erste Elektrode entweder mit einem zweiten Potential oder mit dem Bezugspotential und dessen zweite Elektrode mit Bezugspotential oder dem invertierenden Eingang verbunden ist, mit einem an den Ausgang des Operationsverstärkers geschalteten Komparator, und mit einem Taktgenerator zur Steuerung der Schaltvorgänge, **dadurch gekennzeichnet**, daß das erste Potential gleich dem zweiten Potential ist, das ein Hilfspotential (U) darstellt, und daß der erste ($C_1$) und der zweite Kondensator ($C_2$) Teilkondensatoren eines Differentialkondensators (14) sind.

2. Kapazitive Sensoranordnung nach Anspruch 1, **dadurch gekennzeichnet**, daß der Ausgang des Komparators (7) an einen Eingang eines ersten UND-Gliedes (8) anliegt, an dessen zweiten Eingang der Ausgang des Taktgenerators (3) anliegt, wobei der Ausgang des UND-Gliedes (8) mit einer Schalteranordnung zum Schalten der ersten (2) und/oder zweiten Elektrode des zweiten Kondensators ($C_2$) steuernd verbunden ist und ein invertierter Ausgang des Komparators (7) an einen Eingang eines zweiten UND-Gliedes (11) anliegt, an dessen zweiten Eingang der Ausgang des Taktgenerators (3) anliegt, wobei der Ausgang des zweiten UND-Gliedes (11) mit einer Schalteranordnung zum Schalten der ersten (2) und/oder zweiten Elektrode (5) des ersten Kondensators ($C_1$) steuernd verbunden ist.

3. Kapazitive Sensoranordnung nach Anspruch 1 oder 2, **dadurch gekennzeichnet**, daß ein erster Schalter (1) zum Schalten der ersten Elektrode (2) des ersten Kondensators ($C_1$) und ein zweiter Schalter (4) zum Schalten der zweiten Elektrode (5) des ersten Kondensators ($C_1$) vorgesehen ist, wobei Steuereingänge der beiden Schalter (4; 5) mit dem Ausgang des Taktgenerators (3) oder des zweiten UND-Gatters (11) verbunden sind, daß ein dritter Schalter (9) zum Schalten der ersten Elektrode (2) des zweiten Kondensators ($C_2$) und ein vierter Schalter (10) zum Schalten der zweiten Elektrode (5) des zweiten Kondensators ($C_2$) vorgesehen ist, wobei Steuereingänge der beiden Schalter (9; 10) mit dem Ausgang des ersten UND-Gliedes (8) verbunden sind, und daß der Differentialkondensator (14) als Vierpolkondensator ausgebildet ist.

4. Kapazitive Sensoranordnung nach Anspruch 1 bis 3, **dadurch gekennzeichnet**, daß anstelle des zweiten (4) und des vierten Schalters (10) ein fünfter Schalter vorgesehen ist, dessen Steuereingang mit dem Taktgenerator (3) verbunden ist und an dem die zweite Elektrode (5) des ersten Kondensators ($C_1$) und die zweite Elektrode des zweiten Kondensators ($C_2$) gemeinsam verbunden anliegen und zwischen invertierendem Eingang und Bezugspotential schaltbar sind, der erste Schalter (1) zum Schalten der ersten Elektrode (2) des ersten Kondensators ($C_1$) angeordnet ist, dessen Steuereingang mit dem Ausgang des Taktgenerators (3) oder des zweiten UND-Gatters (11) verbunden ist und der dritte Schalter (9) zum Schalten der ersten Elektrode (13) des zweiten Kondensators ($C_2$) angeordnet ist, wobei dessen Steuereingang mit dem Ausgang des ersten UND-Gatters (8) verbunden ist, und daß der Differentialkondensator (14) als Dreipolkondensator ausgebildet ist.

5. Kapazitive Sensoranordnung nach einem der Ansprüche 1 bis 5, **dadurch gekennzeichnet**, daß an den Komparatorausgang ein Impulsformer angeschlossen ist, der an dessen Eingang Impulse mit einem Tastverhältnis von 0,5 anlegbar sind und dessen Ausgangsimpulse eine Impulsbreite aufweisen, die näherungsweise der Taktperiode der Taktimpulsfolge entsprechen, und daß an diesem Impulsformer ein Tiefpaß angeschlossen ist, dessen Ausgang einen analogen Ausgang darstellt, dessen mittlere Spannung $U_{out}$ im Verhältnis zur Betriebsspannung $V_{dd}$

$$\frac{U_{out}}{V_{dd}} = \frac{C_1}{C_1 + C_2}$$

geteilt ist.

6. Kapazitive Sensoranordnung nach einem der Ansprüche 1 bis 5, **dadurch gekennzeichnet**, daß das Bezugspotential auf Massepotential und das Hilfspotential (U) auf Betriebspannung $V_{dd}$ liegt.

Fig. 1

EP 0 847 138 A2

Fig.2

EP 0 847 138 A2

Fig. 3

Fig. 4

Fig. 5